Europäisches Patentamt

European Patent Office

Office européen des brevets

(11) Publication number: **0 260 061**
**A2**

# (12) EUROPEAN PATENT APPLICATION

(21) Application number: **87307757.2**

(22) Date of filing: **02.09.87**

(51) Int. Cl.⁴: **H01L 29/78** , H01L 27/08 , H03K 17/687

(30) Priority: **08.09.86 US 904994**

(43) Date of publication of application:
**16.03.88 Bulletin 88/11**

(84) Designated Contracting States:
**BE DE FR GB IT NL**

(71) Applicant: **SILICONIX incorporated**
**2201 Laurelwood Road**
**Santa Clara California 95054(US)**

(72) Inventor: **Cogan, Adrian I.**
**1174 Hyde Avenue**
**San Jose California 95129(US)**
Inventor: **Blanchard, Richard A.**
**10724 Mora Drive**
**Los Altos California 94022(US)**

(74) Representative: **Meddle, Alan Leonard et al**
**FORRESTER & BOEHMERT**
**Widenmayerstrasse 4/I**
**D-8000 München 22(DE)**

(54) **MOS-gated transistor.**

(57) A transistor (30) constructed in accordance with our invention includes a substrate (31) of a first conductivity type and first and second regions (32, 33) of a second conductivity type formed within the substrate. A gate (30g1) is formed over the portion of the substrate between the first and second regions. The transistor can operate in either a first mode, in which the first region serves as a source and the second region serves as a drain, or a second mode, in which the first region serves as a drain and the second region serves as a source. During the first mode, the substrate is coupled to the first region and during the second mode, the second region is coupled to the substrate, thereby permitting the transistor to operate in forward or reverse mode, while still biasing the substrate.

FIG._1a.
(PRIOR ART)

FIG._1b.
(PRIOR ART)

## "MOS-GATED TRANSISTOR"

### BACKGROUND OF THE INVENTION

This invention relates to MOS transistors and double diffused MOS ("DMOS") transistors. This invention also relates to structures for electrically biasing the substrate or body region in MOS and DMOS transistors.

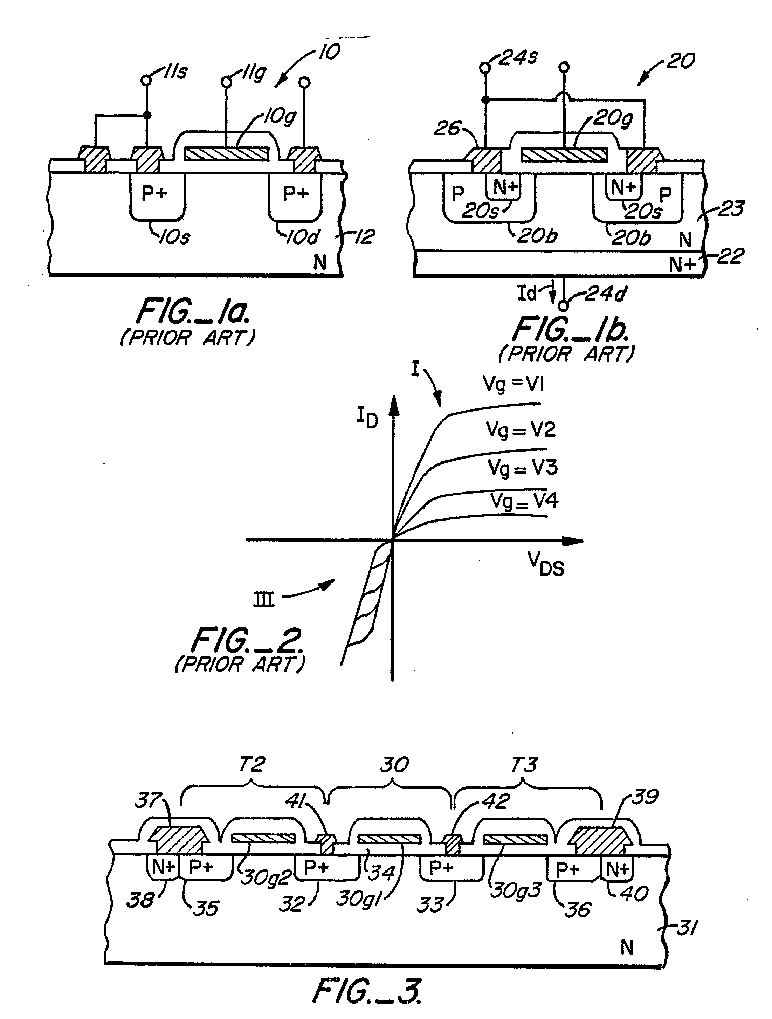

Figure 1a illustrates a typical P channel MOS ("PMOS") transistor 10 constructed in accordance with the prior art. Transistors 10 includes a P+ source 10s and a P+ drain 10d formed in an N type substrate 12. The voltage at P+ source 10s is typically greater than the voltage at drain 10d. Also included in transistor 10 is a gate 10g coupled to a gate lead 11g. When the voltage at gate 10g is lower than the voltage at source 10s by a predetermined threshold voltage and the drain voltage is less than the source voltage, a conductive channel forms between source 10s and drain 10d, thereby permitting current to flow between source 10s and drain 10d. Since the transistor 10 is a P channel transistor, holes from source 10s are therefore permitted to flow to drain 10d.

As illustrated in Figure 1a, the source 10s is connected to a source lead 11s. Substrate 12 is also connected to source lead 11s and is therefore electrically connected to source 10s. This is typically done to prevent substrate 12 from floating with respect to source 10s and acting as a parasitic gate. In other words, if the voltage at substrate 12 were permitted to float with respect to the voltage at source 10s, the electrical characteristics of transistor 10 would vary in an unpredictable way. To prevent this, it is common to connect substrate 12 to source 10s to eliminate this problem. The same technique is also used in conventional N channel MOS ("NMOS") transistors.

Figure 1b illustrates a conventional N channel vertical DMOS transistor 20. As is known in the art, a DMOS transistor is a transistor whose channel length is defined by the difference in diffusion of sequentially introduced impurities from a common edge or boundary. DMOS transistor 20 includes an N type epitaxial layer 23 which serves as a transistor drain and an N+ substrate 22 which serves as a low resistance region for current flow which is coupled to a drain lead 24d. Also included is a P type body region 20b, an N+ source region 20s and a gate 20g. (Although illustrated as two regions, body regions 20b are typically a single region joined outside the cross section of Figure 1b. Source region 20s is also typically a single contiguous region joined outside the cross section of Figure 1b). When the voltage at gate 20g is greater than voltage at source 20s by the threshold voltage of transistor 20, a conductive channel forms between N+ source 20s and substrate 22. As can be seen, source 20s is coupled to a source lead 24s and is also electrically coupled to body region 20b via source metallization 26. Thus, in a conventional DMOS transistor, it is common to connect the body region 20b to the source region 20s to prevent the voltage at body region 20b from floating with respect to source region 20s.

Figure 2 illustrates the electrical characteristics of transistor 20. Specifically, Figure 2 graphs the relationship between drain current Id versus the difference in voltage Vds at drain lead 24d and source lead 24s for various gate voltages Vg. It will be noticed that although the transistor characteristic illustrated in quadrant I of the graph of Figure 2 appears as a normal transistor characteristic curve, the transistor cannot be operated in inverse mode, i.e. with epitaxial layer 23 acting as the transistor source and N+ region 20s acting as the drain. The reason for this is that if the voltage at source 20s were to become greater than the voltage at epitaxial layer 23, the PN junction between body region 20b and epitaxial layer 23 would conduct, and transistor 20 would exhibit the diode-like characteristic curve illustrated in quadrant III of Figure 2. It is noted that transistor 10 of Figure 1a suffers from the same problem, i.e. if one attempted to operate transistor 10 in the inverse mode, with P+ region 10d acting as a source and P+ region 10s acting as the drain, as soon as the voltage at source 10s rose above the voltage at drain 10d, the PN junction between drain 10d and susbtrate 12 would conduct and transistor 10 would function as a conventional diode.

### SUMMARY

A transistor constructed in accordance with the present invention permits symmetrical operation in both the first and third quadrants of the drain current-drain source voltage characteristic curve while ensuring that the voltage at the transistor body region is not permitted to float with respect to the source.

A transistor constructed in accordance with one embodiment of our invention includes a substrate of a first conductivity type, and first and second regions of a second conductivity type formed within the substrate. A gate is formed above and insulated from a portion of the substrate between the first and second regions. In a first mode of operation, the first region acts as the transistor source and the second region acts as the transistor drain and in a second mode of operation, the second region acts as the transistor source and the first region acts as the drain. Of importance, during the first mode of operation, the substrate is electrically coupled to the first region, and during the second mode, the substrate is electrically coupled to the second region.

A transistor constructed in accordance with a second embodiment of our invention includes a substrate of a first conductivity type, a first region of a second conductivity type formed within the substrate, and a second region of the first conductivity type formed within the first region. The transistor operates in either a first mode of operation, with the substrate, first region, and second region serving as the drain, body, and source of the transistor, respectively, or a second mode of operation, with the second region, first region, and substrate serving as the drain, body, and source of the transistor, respectively. In the first mode of operation, the first and second regions are electrically coupled together, while in the second mode of operation, the substrate and first region are electrically coupled together.

## BRIEF DESCRIPTION OF THE DRAWINGS

Figure 1a illustrates an MOS transistor constructed in accordance with the prior art;

Figure 1b illustrates a vertical DMOS transistor constructed in accordance with the prior art;

Figure 2 illustrates the IV characteristic curve of the transistor of Figure 1b;

Figure 3 illustrates a lateral MOS transistor constructed in accordance with one embodiment of the present invention;

Figure 4 schematically illustrates the structure of Figure 3;

Figure 5 illustrates the drain current versus drain/source voltage characteristic curve of transistor 30 of Figure 3;

Figure 6 illustrates a vertical MOS transistor constructed in accordance with our invention;

Figure 7 illustrates a vertical DMOS transistor constructed in accordance with our invention;

Figure 8 illustrates a vertical DMOS transistor constructed in accordance with another embodiment of our invention;

Figure 9 schematically illustrates a switching circuit including the transistor of Figure 8; and

Figure 10 schematically illustrates a circuit including the structure of Figure 3.

## DETAILED DESCRIPTION

Referring to Figure 3, a lateral MOS transistor 30 constructed in accordance with one embodiment of our invention includes an N type semiconductor substrate 31, a first source/drain P+ region 32, a second source/drain P+ region 33, and a gate 30g1 formed above a portion of substrate 31 between regions 32 and 33. Gate 30g1 is electrically isolated from substrate 31 by gate insulation 34. Region 32 and 33 are connected to contact metallization 41 and 42 respectively. As described in detail below, transistor 30 acts in either a first mode, with region 32 serving as the source and region 33 acting as the drain of transistor 30, or a second mode, with region 33 acting as the source and region 32 acting as the drain of transistor 30. Current flow between regions 32 and 33 is controlled by the voltage present at gate 30g1 and the voltage applied to regions 32 and 33.

Also illustrated in Figure 3 is a P+ region 35 and a P+ region 36. Region 35 is electrically coupled to substrate 31 via metallization 37 and N+ region 38 while region 36 is electrically coupled to substrate 31 via metallization 39 and N+ region 40.

Also illustrated in Figure 3 are gates 30g2 and 30g3. Gate 30g2, P+ region 32 and P+ region 35 serve as a transistor T2. When region 32 serves as the source of transistor 30, gate 30g2 is driven with a voltage such that transistor T2 turns on, thereby forming a conductive channel between regions 32 and 35, and coupling region 32 to substrate 31. In this way, when region 32 serves as the source of transistor 30, substrate 31 is held at the same voltage as region 32.

When region 33 serves as the source of transistor 30, gate 30g2 is held at a voltage such that transistor T2 turns off, thereby decoupling substrate 31 from region 32.

When region 33 serves as the source of transistor 30, a voltage is applied to gate 30g3 such that a conductive channel forms between P+ regions 33 and 36, thereby coupling substrate 31 to region 33. In this way, substrate 31 is held at the same voltage as region 33. When region 32 serves as the source of transistor 30, gate 30g3 is held at a voltage such that current can no longer flow between regions 33 and 36, thereby decoupling substrate 31 from region 33.

It will therefore be apparent, in light of this specification, that substrate 31 is coupled to whichever of P+ regions 32 or 33 serves as the source of transistor 30, i.e. whichever of regions 32 or 33 is held at the higher voltage. Because N substrate 31 is automatically held at the higher of the voltages at regions 32 or 33, no matter which of regions 32 or 33 serves as the source of transistor 30, the PN junction between region 32 and substrate 31 and the PN junction between region 33 and substrate 31 will not turn on, and transistor 30 can operate in either of quadrants I or III of its characteristic curve.

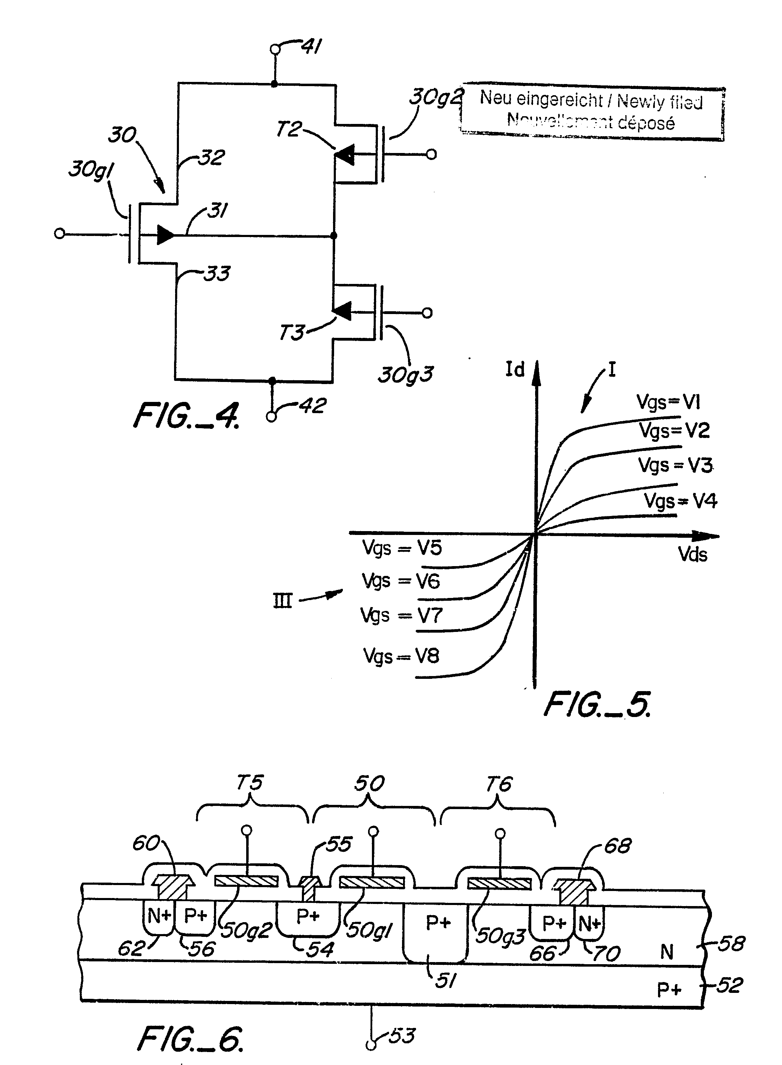

Figure 4 schematically illustrates the structure of Figure 3. Figure 5 illustrates the drain current (Id) versus drain/source voltage (Vds) characteristic curve of transistor 30 for a number of gate voltages (V1 to V8) when transistor 30 is operating in the first and third quadrants. The present invention can also be practiced with an N-type MOS transistor by reversing conductivity types of the various semiconductor regions and substrate 31 of Figure 3 and appropriately modifying the voltages applied to gates 30g1 to 30g3 and regions 32 and 33.

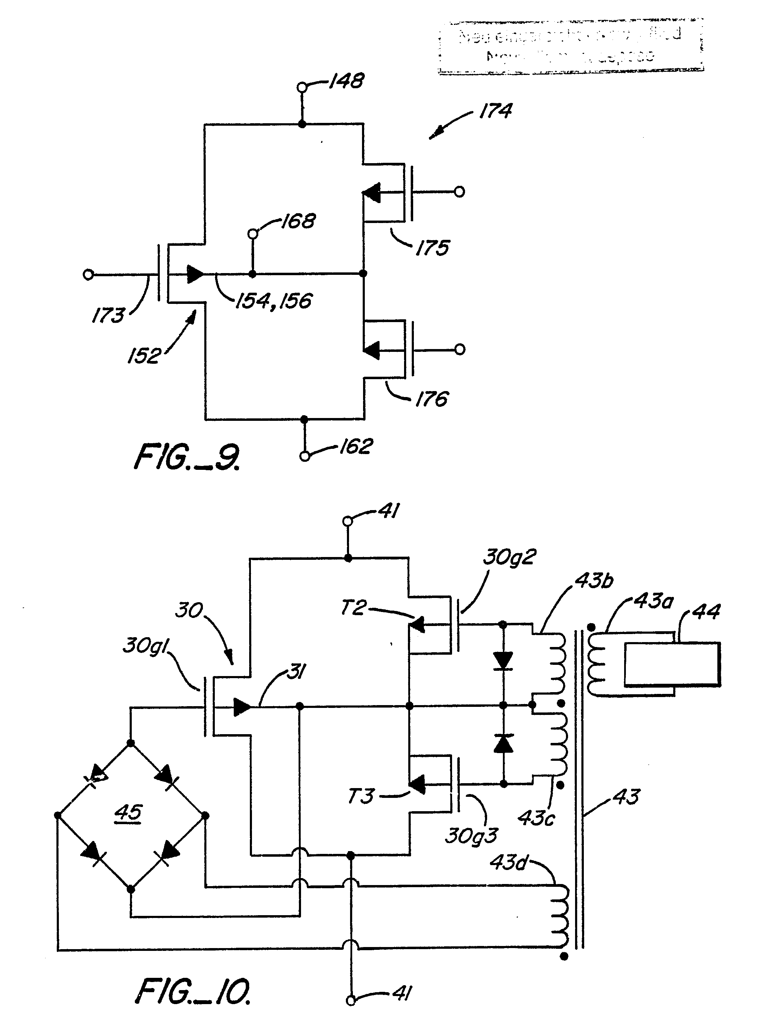

Figure 10 schematically illustrates a circuit including the structure of Figure 3 and a transformer 43 for driving gates 30g1, 30g2 and 30g3. Referring to Figure 10, transformer 43 includes a primary winding 43a for receiving a signal from a control circuit 44. Depending on the polarity of the signal applied to winding 43a, a signal is applied to gate 30g2 via a secondary winding 43b or gate 30g3 via a secondary winding 43c, to turn on transistor T2 or T3, respectively. The polarity of the signal applied to winding 43a depends on whether the voltage at contact metallization 41 is positive or negative relative to the voltage at contact metallization 42.

Transformer 43 also includes a secondary winding 43d for applying a signal to gate 30g1 via a diode bridge 45 in response to the signal applied to winding 43a. Diode bridge 45 ensures that transistor 30 will turn on regardless of the polarity of the signal appearing at winding 43d. Diode bridge 45 is also connected to substrate 31 to ensure that the voltage across winding 43d is applied to gate 30g1 relative to the voltage at substrate 31.

It is noted that control circuit 44 provides the signal at winding 43a in order to turn on transistor 30 during selected time periods as required in the application in which the circuit of Figure 10 is used.

It will be appreciated in light of the disclosure below that transformer 43 can be used to drive the gates of an MOS or DMOS transistor constructed in accordance with the present invention. In addition, transformer 43 can drive the gates of P or N channel devices, although when driving N channel devices the polarity of the diodes should be the opposite of that indicated in Figure 10.

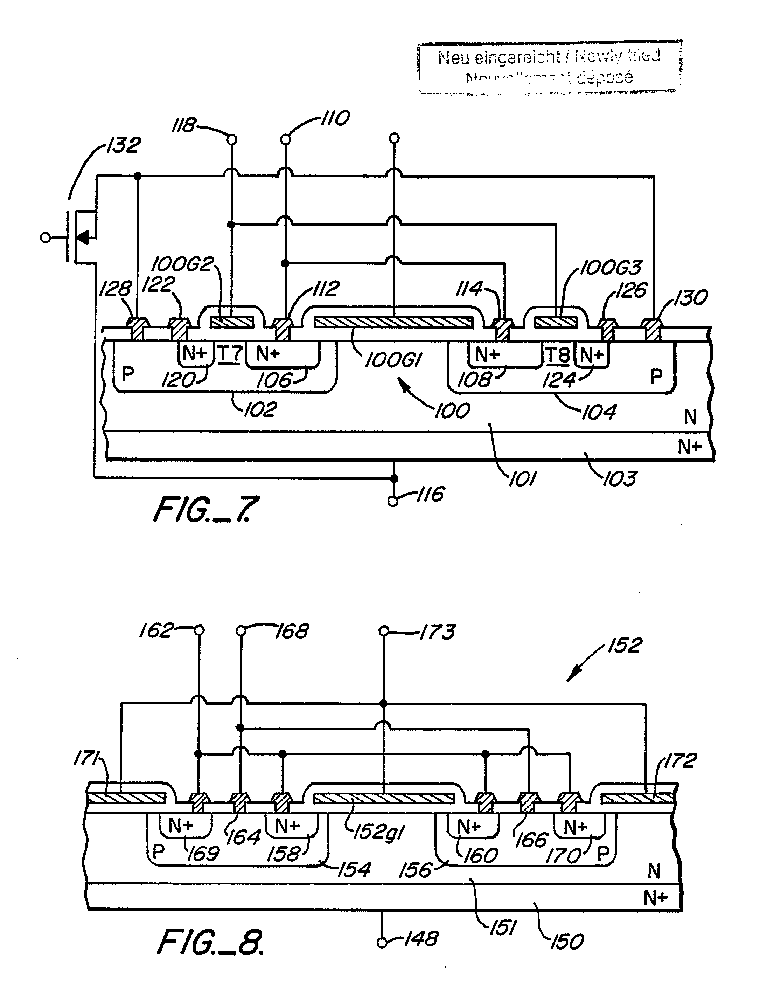

Referring to Figure 6, a vertical PMOS transistor 50 constructed in accordance with one embodiment of our invention includes a P+ region 51 which serves as a first source/drain region, a P+ region 54 which serves as a second source/drain region, metallization 55 for contacting region 54, and a gate 50g1 which serves as the gate of transistor 50. P+ regions 51 and 54 are formed in an N type epitaxial layer 58 which serves as the body region of transistor 50. P+ region 51 electrically contacts a P+ substrate 52, which in turn contacts a bottom side substrate contact 53. When the voltage at source/drain region 54 is greater than the voltage at source/drain region 51 and the voltage at gate 50g1 is less than the voltage at source/drain region 54 minus the threshold voltage of transistor 50, a conductive channel forms between source/drain region 54 and source/drain region 51, thereby permitting current to flow from source/drain region 54 to substrate 52. In this mode of operation, source/drain region 54 serves as the source of transistor 50 and source/drain region 51 serves as the drain. During this mode of operation, the voltage applied to gate 50g2 is less than the voltage at source/drain region 54 minus the threshold voltage of transistor T5, thereby permitting current to flow between source/drain region 54 and P+ region 56. P+ region 56 is coupled to N type body region 58 via metallization 60 and N+ region 62. Accordingly, with transistor T5 on, source/drain region 54 is electrically connected to N type body region 58, thereby preventing the voltage at body region 58 from floating relative to source/drain region 54.

A P+ region 66 formed in body region 58 is electrically coupled to body region 58 via metallization 68 and N+ region 70. When the voltage at source/drain region 54 is greater than the voltage at substrate 52, a gate 50g3 is held at a voltage sufficient to prevent a conductive channel from forming between P+ regions 51 and 66, thereby rendering transistor T6 nonconductive. However, when the voltage at substrate 52 is greater than the voltage at P+ region 54, transistor T5 is off and transistor T6 is on, thereby coupling P+ region 51 to body region 58.

Although transistor 50 of Figure 6 is a P channel device, it will be appreciated by those skilled in the art that by reversing the conductivity types of the illustrated regions, an N channel vertical MOS transistor can be formed in accordance with our invention.

The circuit used to drive gates 50g2 and 50g3 may be similar to the circuit of Figure 10. Alternatively, other types of circuits can be used to drive gates 50g2 and 50g3.

Referring to Figure 7, an N channel vertical DMOS transistor 100 constructed in accordance with our invention includes P type body regions 102 and 104 formed in an N type epitaxial layer 101, formed on an N+ substrate 103. Although illustrated as two separate regions, body regions 102 and 104 are typically a single P type body region joined outside the cross section of Figure 7. Formed within body regions 102 and 104 are N+ source/drain regions 106 and 108, respectively. Although illustrated as separate regions, source/drain regions 106 and 108 are also a single source/drain region joined outside the plane of the cross section of Figure 7. Epitaxial layer 101 serves as the second source/drain region. Source/drain regions 106 and 108 are connected to a source/drain lead 110 via metallization 112 and 114 respectively. Similarly, epitaxial layer 101 is connected to a bottom side source/drain lead 116 via substrate 103. A gate 100g1 controls the flow of current between source/drain regions 106, 108 and epitaxial layer 101.

Also illustrated in Figure 7 are gates 100g2 and 100g3 electrically coupled to a gate lead 118. N+ region 106 and 120 and gate 100g2 serve as a transistor T7 while N+ regions 108 and 124 and gate 100g3 serve as a transistor T8. When the voltage at gate lead 118 is greater than the threshold voltage of transistor T7, an electrically conductive channel forms between source/drain region 106 and N+ region 120. As can be seen, N+ region 120 is electrically connected to body region 102 via metallization 122. Similarly, when the voltage at gate lead 118 is greater than the threshold voltage of transistor T8, an electrically conductive channel forms between source/drain region 108 and N+ region 124. As source/drain region 124 is electrically connected to body region 104 via metallization 126, it will be appreciated that when the voltage at gate lead 118 is greater than the threshold voltage of transistors T7 and T8, source/drain regions 106 and 108 are electrically coupled to body regions 102 and 104, respectively. When the voltage at source/drain lead 110 is greater than the voltage at source/drain lead 116 (i.e. source/drain regions 106, 108 act as the source of transistor 100 and epitaxial layer 101 acts as the drain), the voltage applied to gate lead 118 is greater than the threshold voltage of transistors T7, T8, thereby coupling body regions 102, 104 to source/drain regions 106, 108, respectively, and preventing the voltage at body regions 102, 104 from floating with respect to source/drain regions 106, 108. In the alternative, when the voltage at source/drain lead 116 is less than the voltage at source/drain lead 110 (i.e. substrate 101 acts as the source of transistor 100), the voltage applied to gate lead 118 is less than the threshold voltage of transistors T7 and T8, thereby turning off transistors T7 and T8. When this happens, transistor 100 of Figure 7 functions in the third quadrant of the IV characteristic curve.

In one embodiment, contact metallization 128 and 130 electrically contacts body regions 102 and 104, respectively. An external N channel transistor 132 selectively couples metallization 128, 130 to lead 116 in a manner similar to transistor T2 or T3 (Figure 4) described above. It should be noted that if this external connection is not made, operation in the third quadrant is limited since the voltage at the P body region 102 and 104 will float since regions 102 and 104 are not connected to lead 116. In an alternative embodiment, instead of providing metallization 128 and 130 for electrical connection to transistor 132, metallization 122 and 126 is electrically connected to the source of transistor 132.

Figure 8 illustrates a transistor 152 constructed in accordance with yet another embodiment of our invention. Referring to Figure 8, a bottom side source/drain lead 148 is coupled to an N+ type substrate 150. An N type epitaxial layer 151 formed on substrate 150 serves as a first source/drain region of transistor 152. Formed within epitaxial layer 151 are P type body regions 154 and 156. Body regions 154 and 156 can be a single contiguous region joined outside the plane of Figure 8. Formed within P type body regions 154 and 156 are N+ source/drain regions 158 and 160 which can also be a single region joined outside the plane of Figure 8. A gate 152g1 controls current flow between source/drain regions 158, 160 and epitaxial layer 151. As with the previous embodiments, source/drain regions 158, 160 are connected to a common source/drain lead 162. Of importance, body regions 154, 156 are connected to metallization 164, 166, respectively, which in turn are connected to a common body region lead 168. Because of this, body regions 154 and 156 can be biased via circuitry external to the integrated circuit.

Also illustrated in Figure 8 are N+ regions 169 and 170 electrically coupled to source/drain lead 162, and part of gates 171 and 172 electrically coupled to gate lead 173. Thus, N+ regions 158, 160, 169 and 170 serve as source/drain regions for a single transistor while gates 171, 152g1, and 172 serve as the gate of a single transistor. The structure of Figure 8 is typically just a small portion of a much larger transistor including a number of cells, or areas, similar to the area illustrated in Figure 8.

Figure 9 illustrates a switching circuit 174 for biasing body regions 154, 156. Figure 9 - schematically illustrates transistor 152 including gate lead 173, source/drain lead 148 and source/drain lead 162. Body regions 154, 156 are coupled to a body region lead 168. Also illustrated in circuit 174 are a first P channel transistor 175 coupled between body lead 168 and source/drain lead 148 and a second P channel transistor 176 coupled between source/drain lead 162 and body lead 168. Transistor 175 turns on when the voltage at lead 148 is less than the voltage at lead 162 (i.e. epitaxial layer 151 serves as the source of transistor 152), thereby coupling body regions 154, 156 to lead 148, and transistor 176 turns on when the voltage at lead 162 is less than the voltage at lead 148 (i.e., the source/drain regions 158, 160, 169 and 170 serve as the source of transistor 152), thereby coupling P regions 154, 156 to source/drain regions 158, 160, 169 and 170.

In this embodiment, transistors 175 and 176 can be either external to the integrated circuit of Figure 8 or formed within the integrated circuit of Figure 8.

While the invention has been described with reference to specific embodiments, those skilled in the art will recognize that minor changes can be made in form and detail. For example, the above described transistors can be formed in silicon or other semiconductor material. The transistor gates can be formed from polycrystalline silicon or a metal such as aluminum. The gate insulation between the transistor gates and the underlying semiconductor material can be silicon dioxide or some other insulator. In addition, the transistors can be enhancement or depletion mode transistors. Accordingly, all such changes come within the present invention.

The features disclosed in the foregoing description, in the following claims and/or in the accompanying drawings may, both separately and in any combination thereof, be material for realising the invention in diverse forms thereof.

## Claims

1. A transistor comprising a first semiconductor region of a first conductivity type, a second semiconductor region of a second conductivity type opposite said first conductivity type formed within said first semiconductor region, a third semiconductor region of said second conductivity type formed within said first semiconductor region, and a first gate formed above at least a portion of said first semiconductor region, a conductive channel forming between said second and third semiconductor regions in response to the voltage at said first gate, said transistor characterized by comprising:
coupling means for electrically coupling said second semiconductor region to said first semiconductor region when said second semiconductor region functions as the source of said transistor, said coupling means electrically coupling said first semiconductor region to said third semiconductor region when said third semiconductor region functions as the source of said transistor.

2. The transistor of Claim 1 further characterized in that said coupling means comprises:
a fourth semiconductor region of said second conductivity type formed within said first semiconductor region, said fourth semiconductor region being electrically coupled to said first semiconductor region;
a second gate formed above at least a portion of said first semiconductor region, a conductive channel forming between said second semiconductor region and said fourth semiconductor region in response to the voltage at said second gate;
a fifth semiconductor region region of said second conductivity type formed within said first semiconductor region, said fifth semiconductor region being electrically coupled to said first semiconductor region; and
a third gate formed between said third semiconductor region and said fifth semiconductor region, a conductive channel forming between said fifth and third semiconductor regions in response to the voltage at said third gate.

3. A transistor comprising a first semiconductor region of a first conductivity type, a second semiconductor region of a second conductivity type opposite said first conductivity type formed within said first semiconductor region, a third semiconductor region of said second conductivity type formed within said first semiconductor region, and a first gate formed above at least a portion of said first semiconductor region, a conductive channel forming between said second and third semiconductor regions in response to the voltage at said gate, said transistor characterized by comprising:
means for coupling said first semiconductor region to said second semiconductor region when said second semiconductor region functions as a source of said transistor, and for decoupling said second semiconductor region from said first semiconductor region when said third semiconductor region functions as a source of said transistor.

4. The transistor of Claim 3 further characterized in that said means for coupling comprises:
a fourth semiconductor region of said second conductivity type formed within and electrically coupled to said first semiconductor region; and
a second gate formed above at least a portion of said first semiconductor region, a conductive channel forming between said second and fourth semiconductor regions in response to the voltage at said second gate.

5. A transistor comprising a first semiconductor region of a first conductivity type, a second semiconductor region formed within said first semiconductor region, said second semiconductor region having a second conductivity type opposite said first conductivity type, a third semiconductor region of said first conductivity type formed within said second semiconductor region, and a gate formed above at least a portion of said second semiconductor region, a conductive channel forming between said first and third semiconductor regions in response to the voltage at said gate, said transistor characterized by comprising:

first means for electrically connecting said third semiconductor region to said second semiconductor region when said third semiconductor region functions as the source of said transistor, said first means decoupling said third semiconductor region from said second semiconductor region when said first semiconductor region functions as a source of said transistor.

6. The transistor of Claim 5 further characterized by comprising second means for electrically connecting said first semiconductor region to said second semiconductor region when said first semiconductor region functions as a source of said transistor, said second means decoupling said first semiconductor region from said second semiconductor region when said third semiconductor region functions as a source of said transistor.

7. The transistor of Claim 6 wherein said first means is a second transistor coupled between said third semiconductor region and said second semiconductor region and said second means is third transistor coupled between said first semiconductor region and said second semiconductor region.

8. A transistor comprising a first semiconductor region of a first conductivity type, a second semiconductor region of a second conductivity type opposite said first conductivity type, said second semiconductor region being formed within said first semiconductor region, a third semiconductor region of said first conductivity type formed within said second semiconductor region, and a gate formed above at least a portion of said second semiconductor region, a conductive channel forming between said first semiconductor region and said third semiconductor region in response to the voltage at said gate, said transistor characterized by comprising:

first means for electrically connecting said second semiconductor region to said first semiconductor region when said first semiconductor region serves as the source of said transistor, said first means decoupling said first semiconductor region from said second semiconductor region when said third semiconductor region serves as the source of said transistor.

9. A method comprising the step of providing a transistor including a first semiconductor region of a first conductivity type, a second semiconductor region of a second conductivity type opposite said first conductivity type formed within said first semiconductor region, a third semiconductor region of said second conductivity type formed within said first semiconductor region, and a gate, said method characterized by comprising the steps of:

electrically coupling said first and second semiconductor regions when said second region serves as the transistor source; and

electrically decoupling said first and second semiconductor regions when said third semiconductor region serves as the transistor source.

10. The method of Claim 9 further characterized by comprising the steps of:

electrically coupling said first and third semiconductor regions when said third semiconductor region serves as the transistor source; and

electrically decoupling said first and third semiconductor regions when said second semiconductor region acts as the transistor source.

11. A method comprising the step of providing a transistor including a first semiconductor region of a first conductivity type, a second semiconductor region of a second conductivity type opposite to said first conductivity type within said first semiconductor region, and a third semiconductor region of said first conductivity type within said second semiconductor region, and a gate formed above at least a portion of said second semiconductor region, said method characterized by comprising the steps of:

electrically coupling said first semiconductor region to said second semiconductor region when said first semiconductor region serves as the source of said transistor; and

electrically decoupling said first semiconductor region from said second semiconductor region when said third semiconductor region serves as the source of said transistor.

12. The method of Claim 11 further characterized by comprising the steps of:

electrically coupling said second semiconductor region to said third semiconductor region when said third semiconductor region serves as the transistor source; and

electrically decoupling said second semiconductor region from said third semiconductor region when said first semiconductor region serves as said transistor source.

13. A method comprising the step of providing a transistor including a first semiconductor region of a first conductivity type, a second semiconductor region of a second conductivity type opposite to said first conductivity type within said first semiconductor region, and a third semiconductor region of said first conductivity type within said second semiconducter region, said method characterized by comprising the steps of:

electrically coupling said third semiconductor region to said second semiconductor region when said third semiconductor region serves as the source of said transistor; and

electrically decoupling said third semiconductor region from said second semiconductor region when said first semiconductor region serves as the source of said transistor.

14. A circuit comprising a transistor having first and second semiconductor regions of a first conductivity type, a third semiconductor region of a second conductivity type opposite said first conductivity type, and a gate, a conductive channel forming in said third semiconductor region between said first and second semiconductor regions in response to the voltage at said gate, and a transformer having a primary winding, a first secondary winding and a second secondary winding, said circuit characterized by comprising:

first switch means for coupling said first semiconductor region to said third semiconductor region in response to the signal at said first secondary winding;

second switch means for coupling said second semiconductor region to said third semiconductor region in response to the voltage at said second secondary winding; and

means for applying a control signal to said primary winding.

15. The circuit of Claim 14 further characterized in that said transformer includes a third secondary winding, said circuit including means for receiving a signal at said third secondary winding and driving said gate of said transistor in response thereto, regardless of the polarity of the signal at said third secondary winding.

FIG._Ia.
(PRIOR ART)

FIG._Ib.
(PRIOR ART)

FIG._2.
(PRIOR ART)

FIG._3.

FIG._4.

FIG._5.

FIG._6.

FIG._7.

FIG._8.

FIG._9.

FIG._10.